Europäisches Patentamt

European Patent Office

Office européen des brevets

Veröffentlichungsnummer: **0 384 455**

**A1**

# EUROPÄISCHE PATENTANMELDUNG

Anmeldenummer: 90103443.9

Anmeldetag: 22.02.90

Int. Cl.⁵ **H01L 41/08, H01L 41/04, H01L 41/09**

Priorität: 22.02.89 PL 277857

Veröffentlichungstag der Anmeldung:
**29.08.90 Patentblatt 90/35**

Benannte Vertragsstaaten:
**CH DE FR LI NL**

Anmelder: **POLITECHNIKA WARSZAWSKA**
**Plac Jednosci Robotniczej 1**
**00-661 Warszawa(PL)**

Erfinder: **Orzechowski, Jan**
**Ul. Jaworzynska 7 m6**
**PL-00-634 Warschau(PL)**
Erfinder: **Lstuszek, Antoni**
**Ul. Broniewskiego 101 m5**
**PL-01-877 Warschau(PL)**
Erfinder: **Werner, Ryszard**
**Ul. Piwarskiago 11 m2**
**PL-00-770 Warschau(PL)**

Vertreter: **Füchsle, Klaus, Dipl.-Ing. et al**
**Hoffmann . Eitle & Partner Patentanwälte**
**Arabellastrasse 4**
**D-8000 München 81(DE)**

Piezokeramisches Element.

Die Erfindung betrifft ein Element, das zur Vollführung mechanischer Verlagerungen auf einer geschlossenen Kurve, insbesondere einer Ellipse, vorgesehen ist.

Die erfindungsgemäße Vorrichtung besteht aus drei leitenden Schichten, d.h. aus zwei äußeren Schichten (3 und 5) und einer zwischen den keramischen Schichten (1, 2) liegenden Schicht (4). Die zentrale Schicht ist in zwei bzw. drei Sektoren aufgeteilt.

Das Element kann an eine Antriebseinheit mittels der Leisten (6 und 7) befestigt werden. Über die Gestalt der Bahn, auf welcher das Ende des Tragelementes (8) verlagert wird, entscheidet die den Sektoren vermittels der mit den leitenden Flächen (9a und 9b) der Rille (9) elektrischen Kontakt aufweisenden Leitungen zugeführte Spannungsfolge.

FIG. 1

## Piezokeramisches Element

Die Erfindung betrifft ein piezokeramisches Element (Bieger) zur Durchführung von mechanischen Verlagerungen oder zur Druckkrafterzeugung.

Es sind piezokeramische Elemente aus zwei keramischen und drei leitenden Schichten bekannt. Bisher bekannte Konstruktionslösungen von piezokeramischen Antriebselementen gestatten es, lediglich eine lineare Verlagerung des aktiven Teiles des Elementes gegenüber seinen Befestigungspunkten durchzuführen. Beim Einsatz derartiger Elemente zum Erzeugen mechanischer bidirektioneller Verlagerungen wird somit entweder der in Frage kommende Verlagerungsbereich, meistens bis auf etwa 100 μm beschränkt oder es wird der Einsatz einer Kombination mehrerer Elemente mit unterschiedlichen Aufgaben für einen einfachen Antrieb benötigt.

Das erfindungsgemäße Element ist dadurch gekennzeichnet, daß die innere leitende Schicht mindestens zwei Sektoren aufweist und das Element mit mindestens einem, vorzugsweise keramischen Tragelement versehen ist. Es ist von Vorteil, wenn auf der zum Tragelement gegenüberliegenden Fläche an den Enden der Platte zwei keramische Leisten und auf der Höhe der zentralen leitenden Schicht eine Rille angeordnet ist, deren Fläche innerhalb der Sektoren leitend ist, zu welchen diese Schicht geteilt wurde. Über die Gestalt der Bahn, auf welcher das Ende des Tragelementes verlagert wird, entscheidet die den Sektoren vermittels der zu der entlang der inneren leitenden Schicht verlaufenden Leitungen zugeführte Spannungsfolge.

Ein derartiges Element vollführt, beim einfachen Aufbau, die bisher durch sehr komplizierte elektromechanische Systeme, wie ein Hubmotor, eine Präzisionsschraube, Mutter und Führungselemente, realisierten Aufgaben.

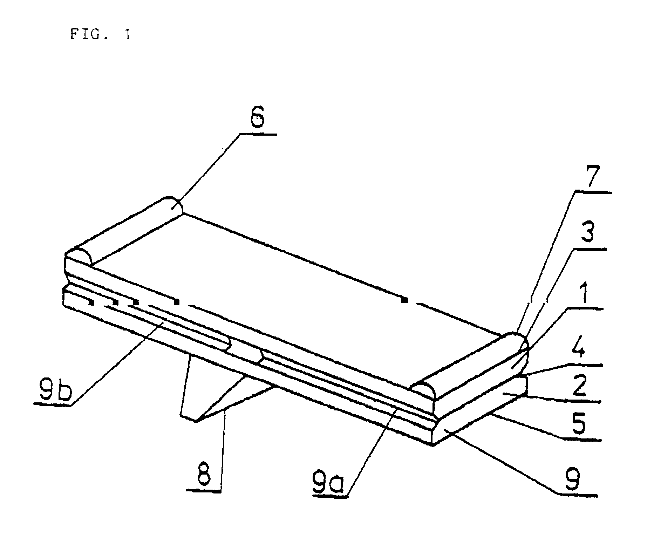

Der Erfindungsgegenstand ist, als Ausführungsbeispiel, in der Abbildung dargestellt, in welcher eine axonometrische Projektion des Elementes gezeichnet ist.

Das erfindungsgemäße piezozeramische Element besteht aus zwei keramischen Schichten 1 und 2, sowie drei leitenden Schichten, d.h. zwei äußeren Schichten 3 und 5 sowie einer zwischen den keramischen Schichten untergebrachten Schicht 4. Die Schicht 4 ist zu zwei Sektoren aufgeteilt, wodurch der einem Sektor entsprechende Teil des Elementes in der gleichen oder in der entgegengesetzten Richtung gegenüber dem dem zweiten Sektor entsprechenden Teil dieses Elementes begoben werden kann. An der der Grenzlinie zwischen den Sektoren entsprechenden Stelle ist senkrecht zu den Schichten ein Tragelement 8 angeordnet, dessen freies Ende auf einer annähernd elliptischen Bahn verlagert werden kann. Das Element kann an die Antriebseinheit mittels isolierender, vorzugsweise keramischer Leisten 6 und 7 befestigt werden, wodurch eine Isolierung der leitenden Schicht 3 von dieser Einheit erzielt wird.

Über die Gestalt der Bahn, auf welcher das Ende des Tragelementes 8 verlagert wird sowie über die Verlagerungsrichtung entscheidet die den beiden Sektoren vermittels der mit den leitenden Flächen 9a und 9b der Rille 9 elektrischen Kontakt aufweisenden Leitungen zugeführte Spannungsfolge. Den äußeren leitenden Schichten 3 und 5 werden Referenzspannungen für die Bewegungssteuersignale zugeführt.

Wenn in drei Sektoren aufgeteilt, weist das Element zwei an den Enden des ersten und des zweiten Sektors angeordnete Tragelemente 8 auf.

## Ansprüche

1. *Piezokeramisches Element*, bestehend aus zwei keramischen Schichten und drei leitenden Schichten, von welchen eine zwischen den keramischen Schichten untergebracht ist, dadurch gekennzeichnet, daß die äußere leitende Schicht (4) vorzugsweise in mindestens zwei Sektoren aufgeteilt ist und daß das Element mit mindestens einem, vorzugsweise keramischen Tragelement (8) versehen ist.

2. Element nach Anspruch 1, dadurch gekennzeichnet, daß auf der dem Tragelement (8) gegenüberliegenden Fläche an den Enden des Elementes die, vorzugsweise aus einem Isolierstoff, insbesondere aus einem keramischen Stoff ausgeführte, erste und die zweite Leiste (6 und 7) angeordnet sind.

3. Element nach Anspruch 1, dadurch gekennzeichnet, daß mindestens entlang einer Seite der Platte, auf der Höhe der zentralen leitenden Schicht (4) eine Rille (9) angeordnet ist, deren Fläche an den den sich aus der Aufteilung dieser Schicht ergebenden Sektoren entsprechenden Abschnitten (9a und 9b) leitend ist.

FIG. 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | DE-A-3212576 (PHILIPS)<br>* Seite 7, Zeile 21 - Seite 8, Zeile 15; Figuren 1-4 *<br>--- | 1 | H01L41/08<br>H01L41/04<br>H01L41/09 |
| A | PATENT ABSTRACTS OF JAPAN<br>vol. 10, no. 24 (E-377)(2081) 30 Januar 86,<br>& JP-A-60 183780 (OLYMPUS) 19 September 85,<br>* das ganze Dokument *<br>--- | 1 | |
| A | PATENT ABSTRACTS OF JAPAN<br>vol. 10, no. 213 (E-422)(2269) 25 Juli 86,<br>& JP-A-61 51886 (MATSUSHITA) 14 März 86,<br>* das ganze Dokument *<br>--- | 1 | |
| A | REVIEW OF SCIENTIFIC INSTRUMENTS.<br>vol. 58, no. 4, April 87, NEW YORK US<br>Seiten 567 - 570; J.R.MATEY et. al.:<br>"Bimorph driven x-y-z translation stage for scanned image microscopy"<br>* Seiten 567 - 568; Figuren 1-2 *<br>--- | 1 | |
| A | PATENT ABSTRACTS OF JAPAN<br>vol. 10, no. 27 (E-378)(2084) 04 Februar 86,<br>& JP-A-60 187270 (NIPPON DENSHIN DENWA KOSHA) 24 September 85,<br>* das ganze Dokument *<br>----- | 2 | RECHERCHIERTE SACHGEBIETE (Int. Cl.5 )<br><br>H01L |

Der vorliegende Recherchenbericht wurde für alle Patentansprüche erstellt

| Recherchenort | Abschlußdatum der Recherche | Prüfer |
|---|---|---|
| BERLIN | 29 MAI 1990 | MUNNIX, S |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
 
& : Mitglied der gleichen Patentfamilie, übereinstimmendes
   Dokument

EPO FORM 1503 03.82 (P0403)